# FASCICULE DE BREVET EUROPEEN

(11) **EP 3 371 826 B1**
(45) Date de publication et mention de la délivrance du brevet: **23.07.2025**
(21) Numéro de dépôt: 16788523.5
(22) Date de dépôt: 28.10.2016
(51) Int. Cl.: H01L 23/498, H01L 21/48, C23C 4/134

(54) **PROCEDE DE FABRICATION D'UN DISPOSITIF A PUCE DE CIRCUIT INTEGRE PAR DEPOT DIRECT DE MATIERE CONDUCTRICE**
HERSTELLUNGSVERFAHREN EINER CHIPVORRICHTUNG MIT INTEGRIERTEM SCHALTKREIS DURCH DIREKTE AUFBRINGUNG EINES LEITERMATERIALS
METHOD FOR MANUFACTURING A DEVICE WITH AN INTEGRATED CIRCUIT CHIP BY DIRECT DEPOSITION OF CONDUCTIVE MATERIAL

(30) Priorité: 05.11.2015 EP 15306756
(43) Date de publication de la demande: 12.09.2018
(73) Titulaire: Thales Dis France SAS, 92190 Meudon (FR)
(72) Inventeur: DEGEILH, Line, 13881 Gemenos Cedex (FR); JANVRIN, Remy, 13881 Gemenos Cedex (FR); DOSSETTO, Lucile, 13881 Gemenos Cedex (FR); LE LOC'H, Alain, 13881 Gemenos Cedex (FR); FIDALGO, Jean-Christophe, 13881 Gemenos Cedex (FR)
(86) Numéro de dépôt international: PCT/EP2016/076159
(87) Numéro de publication internationale: WO 2017/076780

(56) Documents cités:
- EP-A1- 2 840 530
- WO-A1-2012/127135
- DE-A1- 10 223 865
- US-A1- 2001 050 846
- US-A1- 2003 227 528
- US-A1- 2015 021 792
- PERE SERRA ET AL: "Laser-Induced Forward Transfer: Fundamentals and Applications", ADVANCED MATERIALS TECHNOLOGIES, vol. 4, no. 1, 8 August 2018 (2018-08-08), DE, pages 1800099, XP055597607, ISSN: 2365-709X, DOI: 10.1002/admt.201800099
- BOHANDY J ET AL: "Metal deposition from a supported metal film using an excimer Iaser", JOURNAL OF APPLIED PHYSICS, AMERICAN INSTITUTE OF PHYSICS, US, vol. 60, no. 4, 15 August 1986 (1986-08-15), pages 1538 - 1539, XP001309416, ISSN: 0021-8979

## Description

Procédé de fabrication d'un dispositif à puce de circuit intégré par dépôt direct de matière conductrice.

### Domaine de l'invention.

L'invention concerne un procédé de fabrication d'un dispositif à puce de circuit intégré comprenant une étape de dépôt direct de matière conductrice.

Les dispositifs préférentiellement visés appartiennent au domaine technique des dispositifs dont la puce de circuit intégré est sécurisée notamment de par sa structure ou des moyens de sécurité mis en œuvre en fonctionnement. De tels dispositifs sécurisés se trouvent notamment dans l'industrie de la carte à puce.

L'invention vise un procédé de fabrication d'un dispositif à puce de circuit intégré présentant un substrat isolant, des surfaces électriquement conductrices sur le substrat connectées ou couplées à ladite puce de circuit intégré .

Plus particulièrement, l'invention concerne des dispositifs tels que des supports à puce sans-contact, des cartes à puce sans contact, les cartes à double mode de fonctionnement contact et sans contact (interface duale) , des étiquettes électroniques d'identification, des passeports électroniques, des dispositifs à antenne. L'invention vise notamment des documents de voyage électroniques sans-contact (passeports électroniques et visas électroniques), des dispositifs à puce électronique sécurisée.

Ces dispositifs peuvent être conformes aux spécifications de l'ICAO (acronyme de l'expression anglo-saxonne "International Civil Aviation Organization") et/ou norme ISO/IEC 14443.

De tels circuits transpondeurs appartiennent notamment au domaine de la carte à puce sans-contact ou passeport électronique. L'antenne et le condensateur forment généralement un circuit résonant. Le circuit résonant peut être passif ou actif et être relié à une puce de circuit intégré radiofréquence pour communiquer des données avec un lecteur radiofréquence.

Les transpondeurs à puce radiofréquence sont utilisés dans différents domaines économiques tels que le bancaire (porte-monnaie électronique) , la communication, le transport, l'identité (e-passeport, ID-carte) . Dans l'identité notamment, il est connu d'effectuer l'identification d'une personne par communication radiofréquence avec un objet électronique portable sans contact de type RFID.

### Art antérieur.

L'industrie de la carte à puce cherche en permanence des solutions économiques pour fabriquer et connecter des éléments électriquement conducteurs, tels que les modules à puce de circuit intégré et antennes radiofréquences . Des pistes conductrices ou des plages d' interconnexion ou de raccordement sur matières plastiques souples sont habituellement produites par gravure chimique de cuivre (méthode soustractive ) , par tampographie ou par impression d'un matériau conducteur sur le substrat (méthode additive) grâce à la sérigraphie, la flexogravure d'encre conductrice, le jet d'encre ou jet de matière en aérosol.

Il est connu de réaliser des antennes par différentes technologies d'impression notamment additive par impression de métal (sérigraphie, dépôt électrochimique) ou par métallisation soustractive lamination de film métallique sur un substrat puis gravure).

Pour le jet d'encre ou la sérigraphie d'encre conductrice, la formulation ou composition de l'encre est un délicat équilibre entre un liant polymère et des particules métalliques et le solvant dans l'encre. Le liant polymère apporte une adhérence sur un substrat et une cohésion des particules toutefois, le polymère requiert de la température de polymérisation et a l'inconvénient de diminuer la conductivité électrique de la matière déposée et des particules électriquement conductrices en métal .

Les particules apportent de la conductivité électrique des éléments par notamment des opérations ci-après :
- Coalescence (ou frittage) des nanoparticules , (habituellement effectués par l'exposition à des températures élevées ce qui implique que le substrat, généralement plastique polymère, doit être résistant aux hautes températures)
- Réglage de la géométrie des particules métalliques (paillettes d'argent...) et les dimensions. Plus petites sont les particules, plus facile est la coalescence. Mais il faut plus de solvant à évacuer par la température ;
- Utilisation de particules métalliques revêtues pour éviter l'oxydation et provoquer l'agglomération des particules, mais par contre au détriment de la conductivité .

Concernant le solvant, ce dernier est nécessaire pour ajuster la viscosité. Il varie de très faible viscosité pour les têtes de jet d'encre à des viscosités plus élevées pour la sérigraphie .

Par ailleurs, on connaît des procédés de dépôt de matière conductrice sur substrat isolant du type FPC « Fine Powder Coating », d'un côté et LIFT «Laser Induced Forward Transfer» de l'autre côté. Ce sont des procédés mis en œuvre à température ambiante évitant des transferts thermiques pendant ou après un dépôt de matière électriquement conductrice ; Ils permettent l'utilisation de substrats supportant uniquement des basses températures mais ne sont pas adaptés, ni utilisés dans l'industrie de la carte à puce ou pour des dispositifs à puce de circuit intégré sécurisée.

La EP 2 840 530 A1 porte sur un procédé de fabrication d'un dispositif électronique fonctionnant sans contact. Le dispositif électronique comprend un corps isolant électriquement, une cavité ménagée dans le corps, une puce de circuit intégré disposée dans la cavité, un matériau isolant de recouvrement de ladite puce de circuit intégré, et un premier circuit électrique comprenant d'une part, au moins un premier point de raccordement électrique à ladite puce de circuit intégré, ledit au moins un point de raccordement étant disposé dans la cavité et d'autre part, au moins une plage électrique débouchant hors du matériau isolant de recouvrement.

DE 102 23 865 divulgue un procédé de revêtement par plasma de pièces, dans lequel un jet d'un plasma atmosphérique est généré au moyen d'une buse à plasma par une décharge électrique à haute fréquence, jet avec lequel la surface de la pièce à revêtir est revêtue, où un composant du matériau de revêtement est contenu sous forme solide dans une électrode de la buse à plasma et est pulvérisé de l'électrode par la décharge à haute fréquence.

L'article BOHANDY J ET AL, "Metal deposition from a supported metal film using an excimer laser", JOURNAL OF APPLIED PHYSICS, AMERICAN INSTITUTE OF PHYSICS, US, (19860815), vol. 60, no. 4, ISSN 0021-8979, pages 1538 - 1539, XP001309416, et l'article PERE SERRA ET AL: "Laser-Induced Forward transfer: Fundamentals and Applications", Advanced Materials Technologies, vol. 4, no. 1, 8 août 2018, page 1800099, le dernier publié après la date de priorité de la présente demande illustrent les connaissance générales de l'homme du métier en ce qui concerne la technologie "LIFT".

US 2015/021792 A1 divulgue un procédé de fabrication de dispositifs électroniques ayant deux composants connectés par une couche métallique qui comprend l'application d'une couche métallique à chaque composant et la connexion des couches métalliques de façon à former une seule couche métallique.

### Problème technique.

L'invention propose un procédé moins cher que les précédents pour fabriquer et/ou connecter notamment des modules de carte à puce de circuit intégré et/ou antenne.

L'invention propose un procédé simple d'exécution, facile à mettre en œuvre dans l'immédiat et offrant différentes structures possibles.

Elle vise aussi à réduire le nombre d'étapes de fabrication à avoir des inserts électroniques plus fins à insérer dans dispositifs à puce.

Elle vise à conserver de très bonnes propriétés de conduction électrique des pistes pour avoir notamment de bonnes propriétés radiofréquences d'une antenne.

### Résumé de l'invention

L'invention propose des méthodes de dépôt métallique direct à des températures ambiantes ou basse température, typiquement inférieure à 100 °C.

A cet effet, l'invention a pour objet un procédé de fabrication d'un dispositif à puce de circuit intégré sécurisée avec les caractéristiques de la revendication 1.

La formulation de la matière de dépôt est dépourvue de polymère ou de solvant. La formulation de matière à déposer ne contient que du métal .

Selon d'autres caractéristiques du procédé :
- La matière conductrice est du métal pur et lesdites micros particules métalliques sont des micros particules de métal ; La pureté du métal peut être de préférence égale à 100 %, ou supérieure à 98 % ou supérieure à 95 % ;
- La matière a des propriétés d'aptitude au soudage ou au brasage après son dépôt ou son transfert ;
- la matière obtenue a une structure cristalline qui est la même que celle du métal (cuivre, etc..) - Le substrat est choisi parmi un ruban continu diélectrique type carte à puce, un ruban simple face avec des métallisations d'un côté, une plaque plastique notamment type PE, PC, ABS comportant une pluralité d'emplacements d' insert métallisé radiofréquence du type carte à puce ou de passeport électronique radiofréquence ; La matière du substrat peut être notamment en verre-époxy, PET, Polyimide, PEN...
- La technique de transfert ou de dépôt de matière est choisie notamment parmi les techniques FPC ou LIFT ou similaires ;
- Il réalise le dépôt direct à travers un masque M pour la technologie FPC.
- Il comprend une étape de réalisation d'au moins une surface et/ou au moins une piste de redirection et/ou au moins une antenne électriquement conductrice sur un module de type simple face, lesdites surfaces conductrices connectant une puce de circuit intégré via un fil soudé ou via une colle conductrice ;
- Il comprend une étape de réalisation d'au moins une surface électriquement conductrice sur un emplacement de feuille plastique destiné à composer un corps de carte à puce ou un passeport électronique.

Selon d'autres caractéristiques :
- Le dépôt de micros particules métalliques coalescées est dépourvu de polymère ou de solvant ; Les micros particules métalliques coalescées sont également dépourvues de polymère ou trace de solvant à l'intérieur du dépôt ou couche (s) ;
- Le dispositif comprend une connexion électrique de la puce de circuit intégré à la matière conductrice par une soudure ou brasure directement sur ladite matière conductrice.

L'invention vise une application du procédé à la réalisation de dispositif à puce de circuit intégré sécurisée constituant un module de carte à puce, un insert de corps de carte à puce ou feuille de passeport électronique.

Le substrat de ces objets ou dispositifs portant la couche ou plusieurs couches métalliques, est avantageusement choisi en un matériau ayant une température de fusion ou de ramollissement inférieure à 100°C.

Grâce à l'invention, il est possible de faire bénéficier l'industrie de la carte à puce des améliorations ci-après.
- Il n'y a pas de solvant puisque l'énergie du plasma ou du laser est directement utilisée pour transférer le matériau (à l'état liquide) ;
- On obtient une véritable couche dense, cohérente et organisée sans requérir de température élevée (autorisant le recours à des substrats basse température) et donnant une meilleure conductivité ;
- Il est possible de réaliser directement à la suite, des dépôts de matériaux différents ou identiques sans séchage intermédiaire.

### Description des figures :

- La figure 1 illustre un procédé FPC ;
- La figure 2 illustre un procédé LIFT ;
- La figure 3 illustre les étapes du procédé selon un premier mode de réalisation ;
- La figure 4 illustre la réalisation de pistes d'interconnexion sur un module de carte à puce simple face ;
- La figure 5 illustre la réalisation de pistes de redirection et d'interconnexion sur un module de carte à puce simple face ;
- La figure 6 illustre la réalisation d'une antenne sur un module de carte à puce simple face ;
- La figure 7 illustre la réalisation d'une antenne sur un corps de carte à puce ;
- La figure 8 illustre la réalisation de métallisations sur des plages de contact d'un module standard ISO 7816 de carte à puce ;
- La figure 9 illustre un premier mode de réalisation d'une installation industrielle pour la réalisation de métallisations sur un support à puce visé par l'invention ;
- La figure 10 illustre un second mode de réalisation d'une installation industrielle pour la réalisation de métallisations sur un support à puce visé par l'invention.

De nouvelles solutions pour le dépôt direct d'éléments métalliques sur les plastiques ont été élaborées grâce à un dépôt plasma à base de poudre fine (FPC) ou un transfert induit par laser (LIFT).

Des procédés (type DMD) de dépôt direct de métal sur substrat (y compris ceux en plastique comme l'ABS, PMMA, PA, polycarbonate (PC), PEEK PVC...) grâce aux nouveaux plasmas atmosphériques ou « procédé de transfert induit par laser (LIFT)» permettront d'avoir des nouvelles conceptions de module et d'antenne, de nouvelles programmations d'un robot trois-axes supportant la tête d'impression ou le support d'un substrat et/ou déplacement d'un miroir galvanométrique d'un laser.

Les épaisseurs préférées visées aujourd'hui par l'invention s'étendent entre 1 et 30 µm.

La largeur de la ligne formée est comprise entre 10 à 500 µm. Les métaux disponibles aujourd'hui comprennent: Cu, Ni, Sn, Ag, Au, Sn, Al, Pd...

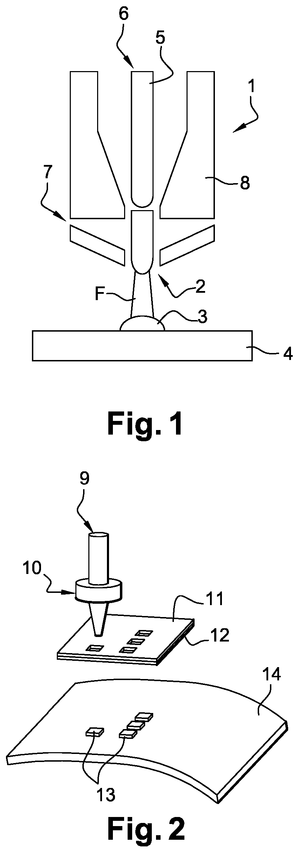

A la figure 1, est illustré un exemple de tête 1 de type FPC (fine powder coating en terminologie Anglo-Saxonne), de dépôt de métal 3 sur un substrat 4 à l'aide d'un jet plasma F de métal. Il comprend principalement une zone de génération du plasma 2 en partie inférieure de la tête 1, une cathode centrale 5 pour l'alimentation électrique de la tête, une anode 8 entourant l'anode centrale, une alimentation en gaz et électricité 6 au niveau de la cathode. Une entrée alimentation 7 de micros particules de métal en poudre fine dans un espace d'amené situé en partie inférieure de la tête 1.

Une telle tête et installation est proposée notamment par la société « Plasmatreat SAS ».

Selon cette entreprise, la technologie FPC référencée sous la marque « Plasma Openair^{®} » est commentée comme ci-après. « Le plasma fait office de moyen de transport sûr et rapide de la poudre chauffée à l'intérieur même de la buse. Au cours du procédé, les fines particules de poudre sont directement injectées dans le faisceau plasma hautement chargé en énergie. Les particules métalliques absorbent l'énergie thermique du plasma. Grâce à la densité élevée du plasma au centre du faisceau, les particules fondent et se lient pour former la couche. L'énergie cinétique du faisceau plasma transporte les particules hors du faisceau plasma Openair^{®} sur le substrat pour former une couche métallique homogène ».

« Dans l'industrie électronique en particulier, FPC permet d'appliquer des traces conductrices fonctionnelles sur supports en plastique - créant des cartes de circuits imprimés sans nécessiter de collage, soudure ou d'autres étapes. »

Ainsi, une telle installation est proposée par la société ci-dessus pour réaliser des dépôts de métal dans différents domaines techniques notamment le domaine électronique pour des cartes de circuit imprimé.

Par contre, ce procédé n'a pas été proposé dans le domaine spécifique de la carte à puce. Il n'est pas indiqué comment il est utilisé, ni pour quelle opération, ni sur quel produit et cela de manière industrielle à cadence élevée. Ce procédé n'est donc pas directement transposable à l'industrie de la carte à puce.

Les domaines d'application visés sont également distincts de celui général des supports portable à puce électronique sécurisée tels que ceux destinés notamment à comprendre (ou mettre en œuvre) des clés cryptographiques de sécurité avec des moteurs cryptographiques internes, des certificats d'authentification, des moyens anti-fraude tels anti-DPA (brouillage d'attaque électronique, des moyens de brouillage d'écoute d'opérations de traitement informatique dans une puce de circuit intégré), de diagnostic ; Ces supports à puce sont utilisés notamment dans des communications sécurisées, des transactions électroniques, transactions bancaires, dans le transport, les télécommunications, la fidélité, le contrôle d'accès, le paiement, les transactions NFC au sens large, l'identification de personnes, l'authentification de dispositifs électronique ou terminaux distants.

Ces supports comprennent la carte à puce, le passeport électronique, le transpondeur radiofréquence sans-contact, des clés USB, des badges sans-contact, la carte de télécommunication SIM, USIM ou autre domaine de l'invention présenté précédemment en introduction. Les dispositifs visés sont conformes à des normes telles que normes bancaires, télécommunication cellulaires, passeport ICAO, ISO/IEC 7816, ISO/IEC 14443, EMVco, ETSI, Globalplatform.

En outre, une telle installation à la figure 1, n'est pas prévue ni envisagée pour fabriquer en quantité industrielle des produits ci-dessus.

La figure 2 illustre quant à elle un autre procédé type LIFT de dépôt de métal 13 par impression sur un substrat receveur 14. Il comprend des moyens de production d'impulsion de faisceau laser 9, un élément de mise en forme (ou focalisation) du faisceau laser, un substrat métallique donneur 12 supporté par un film fin 11 et un support en verre transparent. Le substrat donneur est placé entre le faisceau et le substrat receveur 14.

Le procédé « LIFT » (Laser-induced forward transfer en terminologie anglo-saxone) est un procédé d'impression assisté par laser de films minces absorbants un faisceau laser. Il peut être utilisé pour déposer des matériaux organiques et inorganiques.

Le principe consiste à l'expulsion d'une portion de matière d'un film de matière donneur par évaporation par laser, vers un substrat récepteur. Différents matériaux conducteurs ou isolants peuvent être imprimés de cette manière. Plusieurs passages peuvent être requis pour obtenir une épaisseur désirée de matériau conducteur.

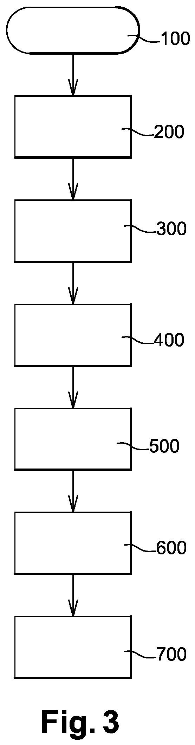

A la figure 3, l'invention selon un mode préféré de mise en œuvre comprend :
- A l'étape 100, le procédé comprend une étape de fourniture d'un module 4A-4E notamment, de type simple face comportant un substrat diélectrique 24 et des métallisations 28 électriquement conductrices sur une première face ; Le substrat comprend des trous ou puits 31 en regard des métallisations rendant les métallisations accessibles à travers les trous du côté d'une seconde face du substrat opposée à la première face.
- A l'étape 200, le procédé comprend une étape de nettoyage et préparation d'au moins une portion de surface visible du côté de la seconde face ; Cette étape consiste à améliorer l'accrochage de la couche de métal à déposer. Elle peut s'effectuer par tout procédé connu de traitement de surface de l'homme de l'art. Toutefois, l'invention prévoit d'effectuer avantageusement cette étape par le même outil à faisceau d'énergie FPC utilisé pour le procédé de dépôt direct de métal ;
- A l'étape 300, on procède le dépôt de couche de métal 3, 13, 23, 33, 43, 53 sur la surface préalablement préparée ou surface cible à recouvrir d'un substrat 4, 24 ;
- A l'étape 400, on peut procéder à une seconde passe pour déposer une couche de métal supplémentaire directement (sans attendre toute opération de séchage ou évaporation de solvant comme dans l'art antérieur) ;
- A l'étape 500, on peut procéder optionnellement au dépôt d'une couche de protection ou de revêtement isolante ou conductrice immédiatement dans la foulée éventuellement avec le même procédé FPC (ou tout autre procédé connu);
- A l'étape 600, sur un autre poste opératoire, on peut procéder au report d'un composant électronique (notamment type SMT : monté en surface ou notamment une puce de circuit intégrée de sécurité nue ou enrobée ; On peut procéder aussi à sa connexion électrique ou son couplage avec les surfaces ou pistes conductrices ainsi créées et/ou avec les métallisations réalisées préalablement sur la première face du substrat ; La connexion peut être effectuée par tout moyen connu : brasage ou soudage notamment par fil soudé ou par colle conductrice notamment anisotropique (pâteuse : ACP, ou en film : AFP) ;
- A l'étape 700, on peut procéder à une opération de protection optionnelle et au moins partielle du composant ou de la puce nue de circuit intégré de sécurité et/ou de ses connexions.

L'épaisseur des couches déposées est par exemple de 1 à 30 µm et la largeur est par exemple comprise pour des pistes de 10 à 500 µm.

Une seule passe ou un passage de l'outil permet d'obtenir une épaisseur comprise entre 1 et 10 µm avec le procédé LIFT tandis qu'avec le procédé FPC, l'épaisseur est inversement proportionnelle à la vitesse de balayage.

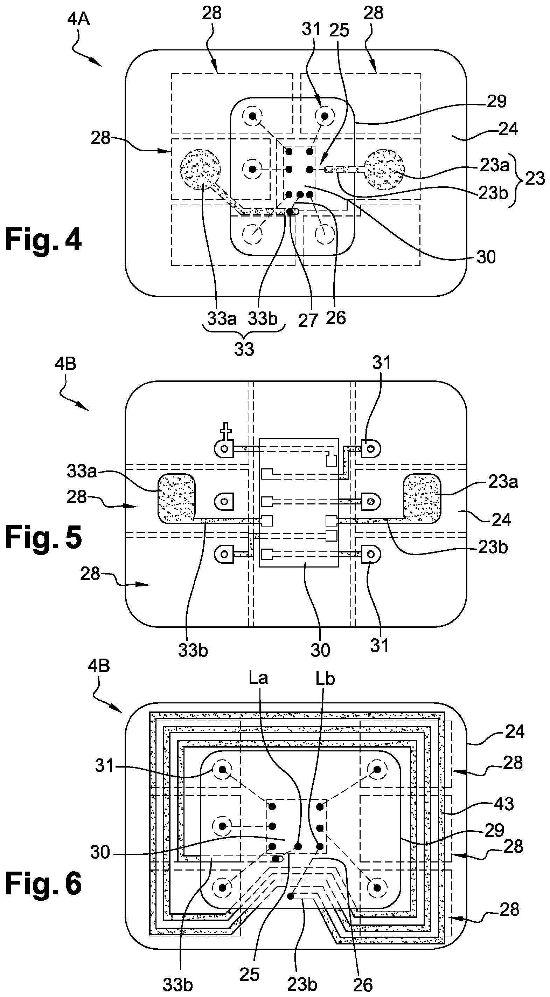

A la figure 4, on va décrire un mode de mise en œuvre du procédé de l'invention pour la fabrication d'un dispositif à puce de circuit intégré sécurisée. Le dispositif fabriqué comprend (ou est constitué) un substrat isolant, des surfaces électriquement conductrices sur le substrat connectées ou couplées à ladite puce électronique ; Les surfaces électriquement conductrices sont réalisées par une étape de dépôt ou transfert direct de matière conductrice notamment sous forme de micros particules. Le dépôt s'effectue à température ambiante ou à froid, c'est à dire à des températures inférieures à la température de fusion de la plupart des plastiques utilisé comme support dans l'industrie de la carte à puce.

Dans l'exemple, le dispositif est illustré sous forme d'un module à puce 4A de circuit intégré de carte à puce ; Il est de type simple face comme décrit précédemment et est fourni avec des plages de contact 28 au format ISO 7816 sur une première face (non visible sur la figure et opposée à la première face) et des trous (ou puits) 31 ménagés à travers un film support diélectrique 24 pour connecter les plages à la puce de circuit intégré 30.

Selon une caractéristique, le procédé comprend une étape de dépôt ou transfert de matière réalisée par une technique de dépôt direct de métal sur le substrat, la matière ayant des propriétés aptes à être soudées ou brasées après dépôt ou transfert.

Ainsi, sur la seconde face (visible sur la figure) du substrat 24, on réalise des plages 23a, 33a d'interconnexion et/ou redirection et/ou des pistes 23b, 33b par un dépôt de métal 23, 33 selon le procédé de l'invention FPC, ou LIFT.

Ces pistes 23a, 33a s'étendant d'une zone à proximité immédiate de la puce pour une connexion à la puce, à une zone plus éloignée recevant la plage d'interconnexion 23a, 33a pour permettre une connexion à une antenne (non illustrée) dans un corps de carte. Ensuite, une puce 30 est reportée, fixée sur le module, connectée par fils soudés d'une part aux plages de contact à travers les puits de passage (trous) des fils de connexion et d'autre part 25, 26 aux pistes 23b, 33b s'étendant jusqu'aux plages d'interconnexion / redirection 23a, 33a.

L'invention permet avantageusement de souder directement les fils 25, 26 de connexion aux pistes 23b, 33b et plages fraichement réalisées par dépôt de métal conducteur 23, 33. Grâce au procédé de dépôt, la couche de métal 23, 33 est de bonne qualité, notamment sur le plan de la conductivité, densité de métal, tenue mécanique et permet une soudure ultérieure.

L'invention permet une très grande flexibilité de dernière minute pour la conception des dessins de pistes et/ou plages conductrices en fonction des puces disponibles sur le marché et/ou en fonction de l'utilisation des modules soit à contact électrique, soit hybride (contact électrique avec un lecteur externe et sans contact).

L'invention utilisant un procédé de type additif, elle permet de déposer du métal uniquement dans les endroits désirés du support avec l'économie de métal résultant.

L'outil est pilotable par commande numérique avec un programme chargeable ou exécuté en fonction du motif de dépôt de métal désiré ou propre à chaque module. Un changement de motif peut intervenir d'un objet quelconque (module) à un autre sur une chaine de production notamment de module carte à puce.

A la figure 5, on fournit comme précédemment un module à contact 24. Les mêmes numéros désignent les mêmes éléments ou sensiblement les mêmes types d'élément d'une figure à l'autre. Ce mode de réalisation diffère du précédent en ce que la puce 30 est reportée en étant retournée (flip-chip) de manière à présenter ses plots de connexion orientés vers la face visible (sur la figure) du module.

Plusieurs pistes de redirection ou d'interconnexion 23b, 33b sont créées sur le substrat. Elles s'étendent d'une zone de connexion à la puce, correspondant à un emplacement de plot de puce pour connecter directement un plot de puce, à un des puits de connexion 31 situés en regard des plages de contact 28 disposés sur la face opposée du film diélectrique 24.

La connexion à l'antenne dans un corps de carte à puce requiert deux pistes 23b, 33b s'étendant respectivement d'un emplacement de plot radiofréquence LA, LB d'une puce sans contact ou à interface double ou mixte (contact et sans contact) à une zone du film diélectrique recevant une plage d'interconnexion 23a, 33a pour connecter ultérieurement une antenne radiofréquence. La puce est ensuite reportée et connectée en flip-chip notamment à l'aide de colle conductrice anisotropique (notamment type AFP, ACP). La puce peut être enrobée d'une résine de protection (non représentée).

Ce mode est économique car permet d'éviter une métallisation des trous obtenus auparavant dans l'art antérieur par croissance électrochimique.

A la figure 6, l'invention permet de réaliser un module à puce de circuit intégré du type module-antenne (portant une antenne et le plus souvent avec des plages de contact électriques) dans lequel, une antenne radiofréquence 43 est portée par le module lui-même plutôt que par le corps de carte à puce radiofréquence.

On fournit un module 4B sensiblement comme celui 4A de la figure 3 à la différence que des pistes de connexion 23b, 33b aux plots radiofréquence LA, LB de la puce sont prolongées par une antenne 43 qui et formée selon le procédé de dépôt de métal proposé par l'invention LIFT ou FPC. L'antenne est ici sous forme de spirale conforme au standard ISO 14443 mais pourrait être d'un autre type par exemple UHF et d'une autre forme notamment dipôle et fonctionnant à une autre fréquence.

La connexion électrique de l'antenne 43 à la puce 30 s'effectue ici de manière classique directement par fil soudé 25, 26 aux plots La, Lb de la puce grâce à la densité et qualité du métal déposé. Ainsi, des techniques et machines classiques éprouvées de l'industrie de la carte à puce électrique peuvent être mises en œuvre, réutilisées pour la connexion de la puce 30.

La connexion électrique de la puce 30 peut être effectuée comme à la figure précédente par puce retournée et connexion par colle conductrice notamment anisotropique.

A la figure 6, un autre mode de mise en œuvre de l'invention prévoit de réaliser une antenne 43 ou des éléments d'antenne directement sur un substrat 24 isolant. Le substrat est ici au format d'un corps de carte à puce et constitue une feuille ou insert (ou inlay sans-contact) de carte à puce radiofréquence. Alternativement, la feuille ou substrat 24 peut constituer un sous-ensemble de feuille de passeport électronique. La feuille est par la suite laminée / assemblée avec d'autres feuilles pour obtenir le produit final.

Un micromodule 45 est reporté sur le substrat 24 par exemple, en ayant la puce 48 et/ou son enrobage placé(s) dans une cavité ménagée dans le substrat 24. Des plages 46, 47 d'interconnexion à l'antenne sont disposées sur une face du micromodule opposée à celle portant la puce. Le micromodule peut prévoir une zone isolante 50 ou pont isolant pour permettre un passage d'éléments d'antenne sur au moins une des plages d'interconnexion 46, 47.

L'antenne 43, ici sous forme de spirale, est réalisée par dépôt selon la technique de l'invention FPC ou LIFT directement sur le substrat 24 à proximité de la périphérie du corps de carte. L'antenne passe sur la zone isolante 50 du module.

Le cas échéant, la puce est reportée en étant retournée (flip-chip) sur les bornes terminales de l'antenne qui sont réalisées dans ce cas avant le report du micromodule sur le substrat 45.

Alternativement, la puce est placée sur le substrat dans une cavité (préalablement existante ou créée par enfoncement de la puce dans le substrat), les plots de la puce étant accessibles en surface du substrat. Puis, l'antenne est réalisée sur le substrat et directement sur les plots de la puce.

Le procédé LIFT ou FPC permet aussi de réaliser des première et seconde plaques de condensateurs sur une face et/ou l'autre face du substrat. Le procédé permet de recouvrir la première plaque d'un isolant avec l'épaisseur voulue et de former une seconde plaque par-dessus l'isolant. L'invention permet de dimensionner la plaque de condensateur nécessaire en fonction de la valeur de capacité à obtenir pour un accord en fréquence recherché, directement sur le substrat. L'invention permet de réaliser l'antenne et/ son condensateur d'accord sur le substrat et de le connecter soit par recouvrement des pistes existantes sur le substrat soit de le souder ultérieurement après formation.

Le dispositif ainsi créé peut recevoir sur une face ou les deux faces opposées une ou plusieurs autre(s) feuille(s) de couverture et/ou de décoration pour former une carte à puce ou une page ou couverture de passeport électronique radiofréquence.

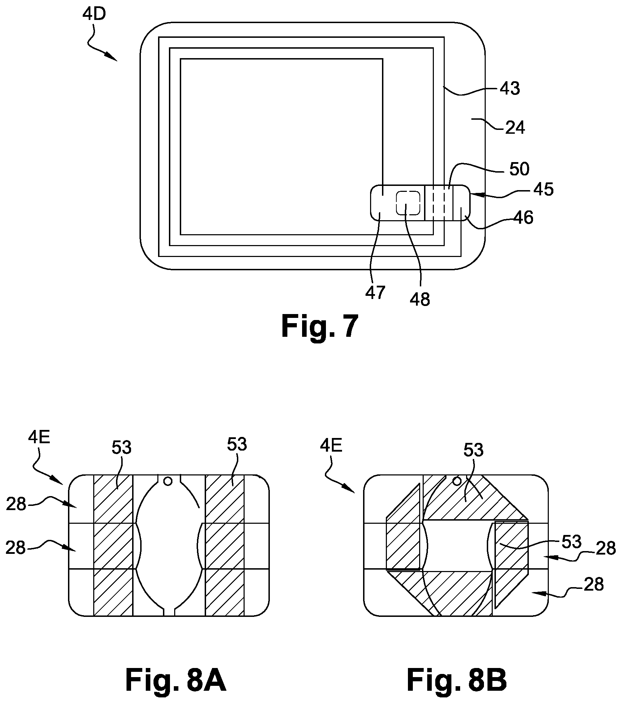

Sur les figures 8A, 8B, l'invention prévoit de réaliser des métallisations 53 sur des modules à contact électrique 4E du côté des plages de contact 28.

A la figure 7A, on réalise un dépôt de métal noble (ex. en or, titane) au niveau des zones 28 normalisées de connexion à un lecteur de carte à puce à six contacts électriques. Le dépôt représente ici deux bandes parallèles espacées.

A la figure 7B, on réalise un dépôt de métal noble (ex. en or, titane) au niveau des zones 28 normalisées de connexion à un lecteur de carte à puce à six contacts électriques. Le dépôt représente ici un motif circulaire composé de quatre zones 53 formant un motif hexagonal à l'extérieur et un rectangle à l'intérieur.

L'invention a ainsi l'avantage de personnaliser graphiquement un module selon un logo spécifique d'un client.

Tout motif peut être réalisé sur les plages de contact à des fins de décoration et/ ou de protection / renforcement contre l'oxydation de certaines zones du module à contact.

Les modes de réalisation ci-dessus aux figures 1 à 5 notamment, en relation avec des modules à contact, peuvent être envisagés sur des substrats ne comportant pas de plage de contact et de connexions aux plages de contact. La puce peut être de type radiofréquence sans être hybride à contacts et sans contact.

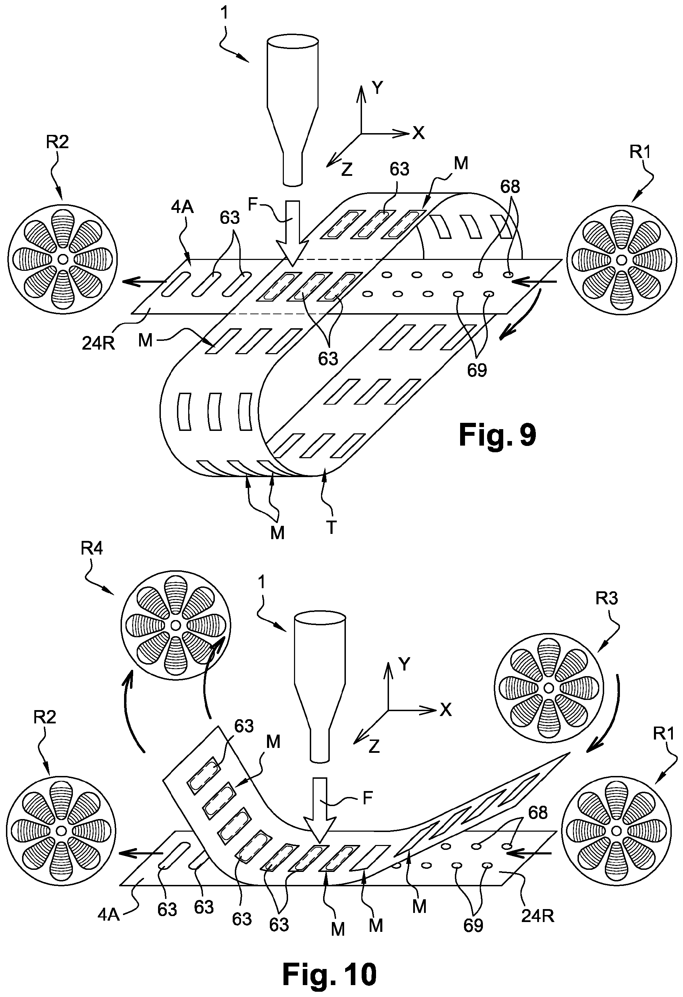

A la figure 9, les procédés FPC ou « LIFT » sont appliqués à la carte à puce. L'installation de production de support à puce électronique sécurisée notamment type carte à puce comprend des moyens d'acheminement par rouleaux ou bobines R1, R2. Ces rouleaux comprennent par exemple un ruban diélectrique tel celui permettant d'obtenir les modules des figures 4 à 8.

Le ruban peut être déjà préalablement métallisé avec des métallisations ou plages conductrices 68, 69 pour fournir un film diélectrique de type simple face. Les métallisations peuvent être sur la face visible sur la figure ou être sur la face opposée. Dans ce dernier cas, les métallisations apparaissent à travers des puits ménagés à travers le film ou ruban. Cette configuration de substrat simple face est similaire à celle de la figure 4 ou 5 ou 6, des puits 31 correspondant aux métallisations ou surfaces conductrices 68, 69. Les métallisations 68, 69 peuvent par exemple appartenir à des plages de contact 28 ou autre surface conductrice réalisées sur la face du ruban non visible sur la figure 9.

Le ruban diélectrique 24R fait office de substrat receveur 4 ou 14 pour produire un substrat continu 4A comportant une pluralité de dépôt conducteur 63 selon l'invention.

Le ruban 24R s'étend sous une buse ou tête 1 d'impression FPC (ou alternativement LIFT) et défile par exemple, pas à pas sous cette tête d'impression de métal.

L'installation comprend d'autre part des moyens de masquage sous forme de ruban T continu également. Ce ruban de masquage 24R comporte une ou plusieurs ouverture(s, fente(s) M formant un motif linéaire correspondant au motif à imprimer ou transférer sur le ruban 24R. Ici, la fente M a la forme d'un rectangle de manière à imprimer une piste d'interconnexion entre deux points (ou surfaces) électriquement conducteurs 68 et 69 portés par le ruban receveur 24R.

Le ruban continu T est agencé de manière à s'étendre sous la tête 1 entre la tête et le substrat receveur continu 24R. On précise encore que ce receveur peut être constitué ou comprendre un ruban métallisé LFCC de type Lead-frame, dans une application des procédés FPC ou LIFT à la production industrielle de carte à puce. Un procédé « R2R » (Reel to Reel : de bobine R1 à bobine R2) est préférentiellement mis en œuvre par l'invention.

En fonctionnement, le ruban 24R et le ruban T sont synchronisés par des moyens de synchronisation de déplacement des rubans de manière que chaque fente M (ici d'une rangée de trois fentes M) se positionne en regard de chaque emplacement de points 68 et 69 (ici une série de trois paires de points 68, 69 électriquement conducteurs).

Lors de l'activation du plasma, la tête projette des particules électriquement conductrices sur le ruban de masquage continu T, dans et autour de la fente M. Ainsi, grâce à l'invention, on peut créer en continu une ligne conductrice 63 sur le ruban 24R à travers la fente ou masque M d'un autre ruban continu T.

L'installation comprend aussi des moyens de récupération du métal (non illustrés) déposé autour du masque et le cas échéant, de préférence des moyens de nettoyage (non illustrés) du ruban et de chaque fente M de manière à retrouver sensiblement les mêmes dimensions initiales des fentes et réutiliser le ruban T. Ces moyens sont de préférence de type mécanique avec des brosses, ou balais ou couteau racleur ou chimique.

Alternativement, des masques amovibles, jetables ou non, sont fixés sur le ruban de masquage T. Le ruban de masquage T comporte alors des fentes ou ouvertures M qui sont plus larges que les fentes M2 des masques amovibles. Les masques amovibles peuvent être enlevés après récupération ou non de la matière déposée autour de chaque fente. Cela permet de réutiliser le ruban de masquage T.

Le cas échéant, c'est le ruban T complet qui est remplacé lorsque les fentes M sont trop obturées par la matière déposée dessus.

A la figure 10, l'installation est similaire à la précédente à la différence que le ruban de masquage T est disposé entre deux bobines R3, R4 disposées au dessus des bobines R1, R2.

L'avantage de cette construction est de pouvoir disposer de masques en continu et non pollués par un passage précédent sous la tête d'impression plasma FPC.

Un autre avantage est de pouvoir synchroniser plus facilement les emplacements des masques par rapport à ceux des emplacements à métalliser. Par exemple, on peut employer des rubans (comme les rubans cinématographiques) avec des perforations latérales des rubans pour un entrainement et calage par roue à picots. Les picots ou des tiges de centrage peuvent pénétrer en même temps les deux rubans au niveau de perforations appartenant aux deux rubans et disposées en regard l'une de l'autre.

Les rubans pollués sont collectés sur la bobine R4 après passage sous la tête et les rubans vierges sont sur la bobine R3 avant passage sous la tête.

La bobine peut ainsi être traitée ultérieurement indépendamment de l'installation de la figure 10 pour récupérer l'excès de métal déposé autour des fentes M.

Les fentes du ruban peuvent être identiques ou de plusieurs types de manière à déposer des motifs différents sur le substrat receveur.

Alternativement, le ruban T peut être remplacé par une plaque (non représenté) comprenant une fente ou une pluralité de fentes identiques ou une pluralité de fentes différentes. Les motifs correspondant aux métallisations à transférer peuvent être complexes ou composés de plusieurs motifs distincts.

Ainsi, par exemple, pour obtenir les pistes 23a, 23b, 33a, 33B, il est possible d'avoir des masques ayant une pluralité d'ensemble de fentes correspondant à l'ensemble des pistes, 23b, 33a, 33B de chaque module 24.

L'invention permet de réaliser des structures en trois dimensions 3D, en empilant la matière tout en ayant une bonne adhérence sur le substrat de base. Les inventeurs ont constaté que l'invention permet de réaliser des colonnes verticales de matière conductrice dans certaines situations (constructions). Alors qu'avec les procédés jet d'encre ou sérigraphique, on obtiendrait des dépôts qui s'étalent et bavent les uns sur les autres pour des situations (constructions) identiques.

L'invention a notamment requis les adaptations suivantes nécessaires à l'industrie de la carte à puce.

Pour FPC, le masque est présenté sur plaque.

Grâce à une modification du convoyage des éléments de transfert figures 9 et 10 (pour FPC), l'invention permet avantageusement de travailler en bobines « Reel to Reel » contrairement aux installations de transfert existantes ou proposés.

Pour LIFT, les substrats donneurs sont actuellement réalisés sur plaque de verre. Il est préférable d'optimiser la matière transférée sans gâche d'un film donneur vers un substrat receveur.

L'invention comprend aussi d'autres applications ci-après.

### Connexion d'une source d'énergie.

Une batterie ou des super-condensateurs peuvent être connectés à un module flexible à circuit intégré ou pour être connecté à un circuit intégré sécurisé avec ces techniques.

Avantageusement, on réalise dans une même opération, la connexion et l'impression d'une partie des pistes conductrices d'un module notamment flexible.

Au moins une électrode de connexion à une batterie ou de super-condensateurs peut être disposée dans le même plan que le module flexible ou empilé sur le module. Les inventeurs ont constaté que dans la mesure où les procédés DMD peuvent imprimer des marches conductrices, la connexion électrique entre deux plans différents est réalisable.

### Connexion d'un afficheur.

Dans le cas d'un afficheur, il existe le problème de la connexion d'une zone de l'afficheur à un microprocesseur pilotant les différents éléments de l'afficheur. Il peut y avoir plus de 40 éléments d'affichage à connecter. L'état de l'art pour connecter un afficheur sur un flexible isolant support est d'utiliser un film ACF conducteur en Z et d'aligner les pistes de l'afficheur (typiquement 30 à 50) et les pistes du flexible isolant. Ici, grâce à l'invention, on peut coller l'afficheur sur un flexible isolant et « tracer » directement des pistes conductrices sur le flexible isolant jusqu'à la zone de connexion de la puce de circuit intégré qui contrôle l'afficheur.

Dans ce cas, (et aussi de manière générale pour connecter électriquement au moins deux éléments entre eux), parce que le procédé DMD est une technique d'impression numérique, il est possible de vérifier le placement de deux éléments séparés (notamment par capteur de position notamment optique, et les connecter malgré un défaut d'alignement en corrigeant, en temps réel, le dépôt de matière conductrice formant au moins un élément d'interconnexion / pistes. Le dépôt s'effectue sur la base d'informations de position des éléments à connecter électriquement, reçues par un dispositif de contrôle du déplacement / positionnement des têtes 1 (ou 9) de dépôt de matière conductrice LIFT et FPC.

### Personnalisation de plages de contacts.

Le procédé selon l'invention DMD peut être utilisé pour effectuer des placages sélectifs.

Avec un produit semi-fini (verre époxy + Cu laminé par exemple), l'invention permet d'éliminer l'oxyde du cuivre et d'effectuer une métallisation selon un modèle spécifique en une ou deux étapes. Par exemple, on peut couvrir d'or des zones de contact ISO plus réduites que les plages de contact entières.

### Autres avantages de l'invention.

- Préparation de la surface du substrat avec faisceau d'énergie (plasma ou laser), modification de l'énergie de surface avec le même système qui effectue le dépôt métallique ;
- Absence de solvant ;
- Comme il n'y a aucune opération après traitement, on peut relier directement sur la même machine plusieurs étapes de dépôt, c'est-à-dire différentes épaisseurs de matériau avec la même tête ou différents matériaux supplémentaires avec une tête de dépôt de matière supplémentaire ;
- Une couche métallique de très bonne cohésion puisque seul le métal (métal pur) est déposé sans autre polymère ou solvant dans la formule de dépôt. La conductivité électrique obtenue est bien meilleure ;

En conséquence, de préférence, l'invention vise un procédé de fabrication d'un dispositif 1 à puce de circuit intégré sécurisée, ledit dispositif présentant un substrat isolant 14, 24, 24R, des surfaces électriquement conductrices 23, 33, 43, 53, 63 sur le substrat connectées ou couplées à ladite puce électronique 30, lesdites surfaces électriquement conductrices étant réalisées par une étape de dépôt ou de transfert de métal pur ; l'étape de dépôt ou transfert de métal pur est réalisée par une technique de dépôt direct de micros particules de métal sur le substrat, ledit dépôt étant obtenu par coalescence des micros particules de métal formant au moins une couche ou plusieurs couches cohésive(s) homogène(s) reposant directement au contact du substrat ; la technique de dépôt visée est du type FPC ou LIFT.
- Le dépôt de matière électriquement conductrice (ou isolante) par LIFT ou FPC, piloté numériquement permet de passer très facilement d'un motif ou modèle de circuit électrique à un autre avec la possibilité pratique de personnalisation de chaque produit distinctement d'un autre produit venant après ;
- Grâce à l'invention, le procédé permet d'obtenir une couche (ou plusieurs) cohésive, dense et homogène déposée directement sur un substrat. La couche (ou plusieurs) ainsi obtenue ne comprend pas ou n'est pas constituée de particules distinctes agglomérées, avec porosités apparentes formées par d'autres procédé notamment de pulvérisation ;
- On obtient une très bonne conductivité électrique d'une couche mono ou multicouche obtenue notamment par une coalescence des nanoparticules à froid. Le substrat peut être choisi parmi ceux qui ne résistent pas à des températures élevées. Le procédé peut s'effectuer à des températures inférieures à 100°C. Les particules déposées sur le substrat n'atteignent pas 100 °C. Le substrat n'atteint pas 100 °C à l'interface avec les particules au cours du procédé de dépôt. Les matériaux de substrat choisis peuvent avoir une température de ramollissement ou de déformation ou de fusion supérieure à 100 °C.
- Plusieurs passages des têtes sur une même surface permettent d'augmenter l'épaisseur requise selon les applications.
- Le processus numérique est également compatible avec un système de contrôle optique en ligne pour analyser et corriger le placement des différents éléments conducteurs à déposer ;
- Possibilité de transfert de métal sur une combinaison d'éléments ou composants électriques et/ou électroniques préassemblés tels que plusieurs modules à puce sécurisée, un module à puce sécurisée et une batterie, une batterie et une antenne, en effectuant dans une même opération, le dépôt de matière et l'interconnexion électrique ;
- Possibilité d'imprimer des marches (ou dénivelés) conductrices et de générer des formes en 3D ;
- Des dispositifs sensibles à la température inférieure à 100°C peuvent être métallisés de cette façon (batteries) ;
- En interne, simplification des différentes matières ou natures des substrats ce qui permet d'être moins dépendants des fournisseurs ;
- Ces technologies sont mises en œuvre à l'air libre à pression atmosphérique normale ;
- Les procédés peuvent être mis en œuvre en bobines (reel to reel) à cadence élevée et plus économiquement comme indiqué aux figures 9 et 10.

## Revendications

1. Procédé de fabrication d'un dispositif (4A) à puce de circuit intégré sécurisée, ledit dispositif présentant un substrat isolant (14, 24, 24R), des surfaces électriquement conductrices (23, 33, 43, 53, 63) sur le substrat isolant connectées ou couplées à ladite puce électronique (30), lesdites surfaces électriquement conductrices étant réalisées par une étape de dépôt ou de transfert de matière conductrice, où ladite étape de dépôt ou transfert de matière conductrice est réalisée par une technique de dépôt direct de micros particules métalliques, dépourvus de polymère ou de solvant, sur le substrat isolant, ledit dépôt étant obtenu par coalescence des micros particules métalliques formant au moins une couche ou plusieurs couches cohésive(s) homogène (s) reposant directement au contact du substrat isolant, **caractérisé en ce qu'**il met en œuvre un défilement continu d'un ruban substrat (24R) receveur de matière conductrice et un ruban continu de masquage (T) pour masquer le substrat receveur.

2. Procédé selon la revendication 1, **caractérisé en ce qu'**il met en œuvre une synchronisation du défilement pas à pas, sous une tête (1) ou laser (9) de transfert, d'un ruban substrat receveur (24R) de matière conductrice et d'un ruban continu de masquage T pour masquer le substrat receveur.

3. Procédé selon l'une quelconque des revendications précédentes, **caractérisé en ce qu'**il comprend des moyens de calage des positionnements relatifs des masques (M) par rapport aux zones (68, 69) à couvrir de matière conductrice.

4. Procédé selon l'une des revendications précédentes, **caractérisé en ce que** ladite matière conductrice est du métal pur et lesdites micros particules métalliques sont des micros particules de métal.

5. Procédé selon l'une des revendications précédentes, **caractérisé en ce que** ladite matière a des propriétés d'aptitude au soudage ou au brasage après son dépôt ou son transfert.

6. Procédé selon l'une des revendications précédentes, **caractérisé en ce que** le substrat est choisi parmi un ruban continu diélectrique type carte à puce LFCC, un ruban simple face (24R) avec des métallisations d'un côté, une plaque plastique, notamment type PE, PC, ABS, verre-époxy, PET, Polyimide, PEN comportant une pluralité d'emplacements d'insert métallisé radiofréquence du type carte à puce ou de passeport électronique radiofréquence.

7. Procédé selon l'une des revendications 1 à 5, **caractérisé en ce que** ladite technique est choisie parmi les techniques FPC ou LIFT.

8. Procédé selon la revendication précédente, **caractérisé en ce qu'**il comprend les étapes suivantes selon laquelle on réalise le dépôt direct à travers un masque (M) pour la technologie FPC.

9. Procédé selon l'une quelconque des revendications 1 à 7, **caractérisé en ce qu'**il comprend une étape de réalisation d'au moins une surface (23a, 23b, 33a, 33B) et/ou au moins une piste de redirection et/ou au moins une antenne électriquement conductrice sur un module de type simple face, lesdites surfaces conductrices connectant une puce de circuit intégré via un fil soudé (25, 26).

10. Procédé selon l'une quelconque des revendications 1 à 7, **caractérisé en ce qu'**il comprend une étape de réalisation d'au moins une surface (23a, 23b, 33a, 33B) et/ou au moins une piste de redirection et/ou au moins une antenne électriquement conductrice sur un module de type simple face, lesdites surfaces conductrices connectant une puce de circuit intégré via une colle conductrice.

11. Procédé selon l'une quelconque des revendications 1 à 9, **caractérisé en ce qu'**il comprend une étape de réalisation d'au moins une surface (23a, 23b, 33a, 33b) sur un emplacement de feuille plastique destiné à composer un corps de carte à puce ou un passeport électronique.

12. Procédé selon l'une des revendications 1 à 7, **caractérisé en ce qu'** il comprend une étape de dépôt de matière conductrice (3) sur des surfaces métalliques.

## Patentansprüche

1. Verfahren zur Herstellung einer Vorrichtung (4A) mit einem sicheren integrierten Schaltungschip, wobei die Vorrichtung ein isolierendes Substrat (14, 24, 24R) und elektrisch leitfähige Oberflächen (23, 33, 43, 53, 63) auf dem isolierenden Substrat aufweist, die mit dem elektronischen Chip (30) verbunden oder gekoppelt sind, wobei die elektrisch leitfähigen Oberflächen durch einen Schritt der Abscheidung oder Übertragung von leitfähigem Material hergestellt werden, wobei der Schritt der Abscheidung oder Übertragung von leitfähigem Material durch eine Technik der direkten Abscheidung metallischer Mikropartikel, frei von Polymer oder Lösungsmittel, auf dem isolierenden Substrat durchgeführt wird, wobei die Abscheidung durch Koaleszenz der metallischen Mikropartikel erreicht wird, wodurch mindestens eine oder mehrere homogene, zusammenhängende Schichten gebildet werden, die direkt in Kontakt mit dem isolierenden Substrat aufliegen, **dadurch gekennzeichnet, dass** es einen durchgehenden Durchlauf eines Substratbandes (24R), das leitendes Material aufnimmt, und eines durchgehenden Maskierungsbandes (T) zum Maskieren des Aufnahmesubstrats implementiert.

2. Verfahren nach Anspruch 1, **dadurch gekennzeichnet, dass** es eine Synchronisierung des schrittweisen Durchlaufs eines Aufnahmesubstratbandes (24R) aus leitfähigem Material und eines durchgehenden Maskierungsbandes T zum Maskieren des Aufnahmesubstrats unter einem Übertragungskopf (1) oder -laser (9) durchführt.

3. Verfahren nach einem der vorstehenden Ansprüche, **dadurch gekennzeichnet, dass** es Mittel zum Feststellen der relativen Positionierungen der Masken (M) in Bezug auf die mit leitfähigem Material zu bedeckenden Zonen (68, 69) umfasst.

4. Verfahren nach einem der vorstehenden Ansprüche, **dadurch gekennzeichnet, dass** das leitfähige Material reines Metall und die metallischen Mikropartikel Mikropartikel aus Metall sind.

5. Verfahren nach einem der vorstehenden Ansprüche, **dadurch gekennzeichnet, dass** das Material nach seiner Abscheidung oder Übertragung zum Schweißen oder Löten geeignete Eigenschaften aufweist.

6. Verfahren nach einem der vorstehenden Ansprüche, **dadurch gekennzeichnet, dass** das Substrat ausgewählt wird aus einem durchgehenden dielektrischen Band vom Typ LFCC-Chipkarte, einem einseitigen Band (24R) mit einseitigen Metallisierungen, einer Kunststoffplatte, insbesondere vom Typ PE, PC, ABS, Glas-Epoxid, PET, Polyimid, PEN, die eine Vielzahl von hochfrequenzmetallisierten Steckplätzen vom Typ Chipkarte oder elektronischer Hochfrequenzreisepass aufweist.

7. Verfahren nach einem der Ansprüche 1 bis 5, **dadurch gekennzeichnet, dass** die Technik ausgewählt wird aus den Techniken vom Typ FPC oder LIFT.

8. Verfahren nach dem vorstehenden Anspruch, **dadurch gekennzeichnet, dass** es die folgenden Schritte umfasst, bei denen die direkte Abscheidung durch eine Maske (M) für die FPC-Technologie durchgeführt wird.

9. Verfahren nach einem der Ansprüche 1 bis 7, **dadurch gekennzeichnet, dass** es einen Schritt zur Erstellung mindestens einer Oberfläche (23a, 23b, 33a, 33B) und/oder mindestens einer Umleitungsspur und/oder mindestens einer elektrisch leitfähigen Antenne auf einem einseitigen Modul umfasst, wobei die leitfähigen Oberflächen den integrierten Schaltungschip über einen Lötdraht (25, 26) verbinden.

10. Verfahren nach einem der Ansprüche 1 bis 7, **dadurch gekennzeichnet, dass** es einen Schritt zur Erstellung mindestens einer Oberfläche (23a, 23b, 33a, 33B) und/oder mindestens einer Umleitungsspur und/oder mindestens einer elektrisch leitfähigen Antenne auf einem einseitigen Modul umfasst, wobei die leitfähigen Oberflächen einen integrierten Schaltungschip über einen Leitkleber verbinden.

11. Verfahren nach einem der Ansprüche 1 bis 9, **dadurch gekennzeichnet, dass** es einen Schritt zur Erstellung mindestens einer Oberfläche (23a, 23b, 33a, 33b) auf einer Stelle einer Kunststofffolie umfasst, die dazu bestimmt ist, einen Chipkartenkörper oder einen elektronischen Reisepass zu bilden.

12. Verfahren nach einem der Ansprüche 1 bis 7, **dadurch gekennzeichnet, dass** es einen Schritt des Abscheidens von leitfähigem Material (3) auf Metalloberflächen umfasst.

## Claims

1. Method for manufacturing a device (4A) with a secure integrated circuit chip, the device having an insulating substrate (14, 24, 24R), electrically conductive
surfaces (23, 33, 43, 53, 63) on the insulating substrate
connected or coupled to the electronic chip (30), the electrically conductive surfaces being produced by a step of depositing or transferring conductive material, the step of depositing or transferring conductive material being carried out by a technique of directly depositing polymer- or solvent-free metal microparticles onto the insulating substrate, the deposit being obtained by coalescence of the metal microparticles forming at least one or several uniform cohesive layer(s)that rest(s) directly in contact with the insulating substrate, **characterized in that** the method implements a continuous movement of a substrate ribbon (24R) receiving conductive material and a continuous masking ribbon (T) for masking the receiving substrate.

2. Method according to claim 1, **characterized in that** it implements synchronization of the step-by-step movement of a substrate ribbon (24R) receiving conductive material and of a continuous masking ribbon T for masking the receiving substrate under a transfer head (1) or laser (9).

3. Method according to any of the preceding claims, **characterized in that** it comprises means for adjusting the relative positions of the masks (M) with respect to the zones (68, 69) to be covered with conductive material.

4. Method according to any of the preceding claims, **characterized in that** the conductive material is pure metal and the metal microparticles are metal microparticles.

5. Method according to any of the preceding claims, **characterized in that** the material has properties of suitability for soldering or brazing after it has been deposited or transferred.

6. Method according to any of the preceding claims, **characterized in that** the substrate is selected from a continuous dielectric ribbon of the LFCC smart card kind, a single-sided ribbon (24R) with metallizations on one side, a plastic plate, in particular of the PE, PC, ABS, glass-epoxy, PET, Polyimide or PEN kind, comprising a plurality of radio-frequency metallized insert locations of the smart card or radio-frequency electronic passport kind.

7. Method according to any of claims 1 to 5, **characterized in that** the technique is selected from FPC or LIFT techniques.

8. Method according to the preceding claim, **characterized in that** it comprises the following steps according to which direct deposition is carried out through a mask (M) for the FPC technology.

9. Method according to any of claims 1 to 7, **characterized in that** it comprises a step of producing at least one surface (23a, 23b, 33a, 33B) and/or at least one redirection track and/or at least one electrically conductive antenna on a single-sided module, the conductive surfaces connecting an integrated circuit chip via a soldered wire (25, 26).

10. Method according to any of claims 1 to 7, **characterized in that** it comprises a step of producing at least one surface (23a, 23b, 33a, 33B) and/or at least one redirection track and/or at least one electrically conductive antenna on a single-sided module, the
conductive surfaces connecting an integrated circuit chip via a conductive adhesive.

11. Method according to any of claims 1 to 9, **characterized in that** it comprises a step of producing at least one surface (23a, 23b, 33a, 33b) in a location of a plastic sheet intended to constitute a smart card body or an electronic passport.

12. Method according to any of claims 1 to 7, **characterized in that** it comprises a step of depositing conductive material (3) on metal surfaces.
